# EUROPÄISCHE PATENTSCHRIFT

(11) **EP 2 018 521 B1**
(45) Veröffentlichungstag und Bekanntmachung des Hinweises auf die Patenterteilung: **01.04.2015**
(21) Anmeldenummer: 07720122.6
(22) Anmeldetag: 04.05.2007
(51) Int. Cl.: G01D 11/24, H03K 17/95

(54) **INDUKTIVER SENSOR UND ABSCHLUSSKAPPE FÜR INDUKTIVEN SENSOR**
INDUCTIVE SENSOR AND SEALING CAP FOR AN INDUCTIVE SENSOR
CAPTEUR INDUCTIF ET CAPOT DE FERMETURE DESTINÉ À UN CAPTEUR INDUCTIF

(30) Priorität: 12.05.2006 CH 781062006
(43) Veröffentlichungstag der Anmeldung: 28.01.2009
(73) Patentinhaber: Baumer Electric AG, 8500 Frauenfeld (CH)
(72) Erfinder: JENNE, Bernd, 78465 Konstanz (DE); REETMEYER, Burkhard, 78462 Konstanz (DE)
(74) Vertreter: Strauss, Steffen
(86) Internationale Anmeldenummer: PCT/CH2007/000225
(87) Internationale Veröffentlichungsnummer: WO 2007/131373

(56) Entgegenhaltungen:
- EP-B1- 0 149 217
- DE-A1- 1 915 044
- DE-A1- 4 418 570
- DE-U1- 20 019 542
- DE-U1- 20 211 087
- DE-U1- 29 907 642
- US-A- 5 801 530

## Beschreibung

Gegenstand der Erfindung ist ein induktiver Sensor und eine Abschlusskappe für einen induktiven Sensor gemäss den Merkmalen der Patentansprüche 1 und 6. Näherungsschalter und Distanzsensoren, die mittels unterschiedlicher physikalischer Prinzipien den Abstand von Objekten erfassen und in Abhängigkeit des Objektabstandes ein digitales oder analoges elektrisches Ausgangssignal erzeugen, umfassen oft ein zylindrisches oder ein quaderförmiges Gehäuse aus Metall oder Kunststoff. Bei zylindrischen Gehäusen ist an der äusseren Mantelfläche meistens ein Gewinde zum Befestigen des Sensors an einem Maschinenteil ausgebildet.
Induktive Näherungsschalter und Wegaufnehmer umfassen in der Regel einen Oszillator mit einer in einen Schalenkern aus Ferrit eingesetzten Spule, eine Auswertestufe und einen Ausgangsverstärker. Bei zylindrischen Sensoren ist die Spule im Bereich des einen Hülsenendes angeordnet, wobei die Spuleneinheit meistens mittels einer bündig zur Hülse angeordneten oder die Hülse überragenden Kappe oder Abschlusskappe aus Kunststoff oder Keramik abgedeckt ist. Im Gehäuseinneren ist ein Print bzw. eine Leiterplatte mit den zur Ansteuerung des Oszillators und zur Auswertung der Sensormessgrösse erforderlichen Bauteilen angeordnet. Die Leiterplatte kann z.B. mittels mechanischer Verbindungsmittel rückseitig am Schalenkern befestigt sein. Die Enden des Spulendrahtes, der in der Regel auf einen separaten Spulenträger mit zwei Flanschen aufgewickelt ist, werden bei solchen bekannten Sensoren durch Löten elektrisch mit Kontaktflächen auf dem Print verbunden. Am gegenüberliegenden Ende des Prints sind weitere Kontaktflächen zum Festlöten eines Anschluss-Steckers oder eines Kabels ausgebildet. Diese bilden die Schnittstelle des Sensors nach aussen.
Bei der Fertigung herkömmlicher Sensoren wird das Innere des Gehäuses z.B. von der Anschlussseite her mit einem aushärtenden Giessharz vergossen, nachdem der Print und die Spuleneinheit in die Hülse eingesetzt und frontseitig die Abschlusskappe aufgesetzt worden sind. Anschliessend wird auch der rückseitige Abschlussstopfen mit den nach aussen geführten Kontakten auf die Hülse aufgesetzt. Selbstverständlich sind auch leicht abweichende Verfahren zum Zusammenbau solcher Sensoren bekannt.
Die Fertigung bzw. der Zusammenbau solch herkömmlicher Sensoren ist verhältnismässig aufwändig und teuer.

Es ist deshalb Aufgabe der vorliegenden Erfindung, eine Abschlusskappe für einen einfach und kostengünstig herstellbaren induktiven Sensor und einen derartigen Sensor zu schaffen.

Diese Aufgabe wird gelöst durch einen induktiven Sensor und eine Abschlusskappe für einen induktiven Sensor gemäss den Merkmalen der Patentansprüche 1 und 6 Vorteilhafte Ausgestaltungen sind in den Unteransprüchen beschrieben. Ein grundlegender Gedanke der vorliegenden Erfindung ist es, die Abschlusskappe und den Spulenträger einstückig auszubilden und so den Herstellprozess zu vereinfachen. Es können auch mehrere Spulenträger zur Aufnahme mehrerer Spulen an der Abschlusskappe ausgebildet sein. Die Abschlusskappe dient somit als Haltemittel für eine oder mehrere Spulen und entsprechende topfartige Ferritkerne oder Schalenkerne. Diese werden von der Rückseite her über die Spulen und die rückseitigen Flansche der integrierten Spulenträger gestülpt. Durch zusätzliche Ausbildung geeigneter Haltemittel an der Abschlusskappe zum Aufnehmen eines Prints bzw. einer Leiterplatte können im Vergleich zu herkömmlichen Sensoren weitere Teile eingespart und der Herstellprozess weiter vereinfacht werden. Diese Haltemittel sind bei einer besonders vorteilhaften Ausgestaltung der Erfindung so ausgebildet, dass sie Metallisierungen oder andere Kontaktelemente umfassen, mit denen die Spule bzw. die Spulen mit dem Print elektrisch verbunden werden können. Insbesondere besteht die Möglichkeit zur Herstellung lötfreier elektrischer Verbindungen zwischen Spulen und dem Print. Die Abschlusskappe wird mittels thermischer oder nicht thermischer Fügeverfahren wie Laserschweissen, Ultraschallschweissen oder Kleben mit dem Sensorgehäuse bzw. mit einem Teil des Sensorgehäuses dicht verbunden.

Das Sensorgehäuse kann in einer bevorzugten Ausgestaltung einen äusseren, in der Regel metallischen Gehäusemantel mit einem an dessen Innenseite angespritzten Innenmantel aus Kunststoff umfassen. Dieses Gehäuse ist vorzugsweise zylindrisch oder zylinderähnlich mit rundem Gehäusequerschnitt und mit oder alternativ ohne Aussengewinde an der Aussenhülse ausgebildet. Alternativ kann das Gehäuse auch eine quadratische, eine rechteckige oder eine beliebige andere Querschnittform aufweisen und/oder ganz aus Kunststoff gefertigt sein oder einen inneren Gehäusemantel umfassen, der zwar aus Kunststoff gefertigt ist, nicht aber an einen äusseren Gehäusemantel angespritzt ist. Die elektrische Verbindung der Sensorelemente mit dem Print kann z.B. durch Anlöten oder Bonden von Anschlussdrähten oder alternativ mittels Steckverbindern hergestellt.
Nach dem Einschieben des Prints in das Gehäuse wird die Abschlusskappe bzw. der Abschlussdeckel im Randbereich mit dem frontseitigen Ende des Innenmantels verbunden. Dadurch wird der vordere Teilraum des Gehäuses dicht abgeschlossen. Die Enden des Innenmantels können z.B. flanschartig ausgebildet sein und den vorderen Rand der äusseren Mantelhülse ein wenig überragen. Bei alternativen Ausgestaltungen kann der stirnseitige Rand der äusseren Mantelhülse das Ende der inneren Mantelhülse auch überragen oder bündig zu diesem angeordnet sein. Im Gegensatz zu herkömmlich gefertigten Sensoren ist ein Vergiessen des Gehäuseinneren mit einer aushärtenden Vergussmasse nicht erforderlich, bei Bedarf aber trotzdem möglich. Selbstverständlich können in diesem Fall auch andere Ausführungsformen des erfindungsgemässen Sensorgehäuses verwendet werden, die z.B. Füll- und Entlüftungsöffnungen und ev. anders ausgebildete Kontaktelemente umfassen.

Anhand einiger Figuren wird die Erfindung im Folgenden am Beispiel eines zylindrischen induktiven Näherungsschalters näher beschrieben. Dabei zeigen
- Figur 1: einen Längsschnitt eines induktiven Näherunsschalters,
- Figur 2: eine perspektivische Ansicht einer Abschlusskappe,
- Figur 3: ein Detail eines Längsschnittes durch einen weiteren Näherungsschalter.

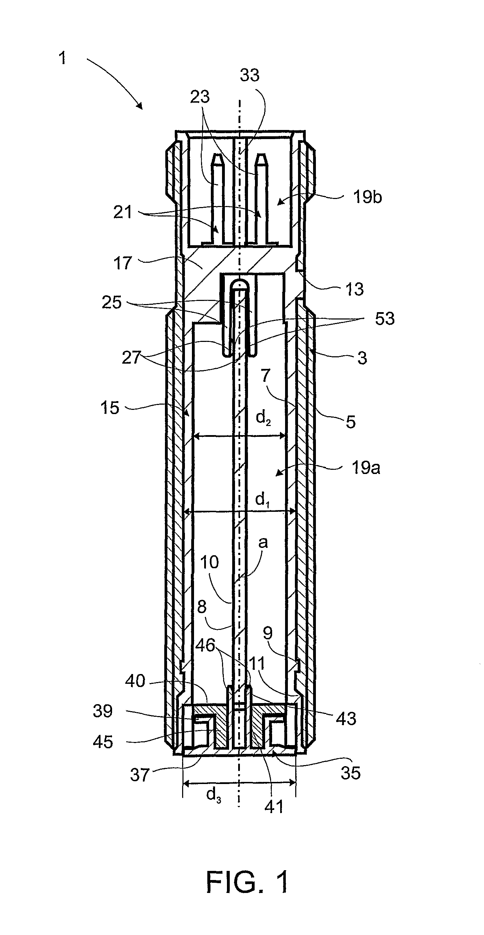

Figur 1 zeigt einen Längsschnitt durch einen induktiven Näherungsschalter 1 mit einem aus Metall gefertigten zylindrischen äusseren Gehäusemantel 3, auch Metallhülse oder Hülse genannt. Die Gehäuseachse a ist durch eine strichpunktierte Linie dargestellt. Der vordere Bereich der Metallhülse umfasst ein Aussengewinde 5 für die Montage des Sensors an seinem Bestimmungsort, beispielsweise an einem Maschinenteil. An der Innenwand 7 des äusseren Gehäusemantels 3 sind radial umlaufende Kerben oder Nuten 9 und Absätze 11 ausgebildet, sodass die Hülse in Abhängigkeit der axialen Position unterschiedliche Querschnitte oder Innendurchmesser d₁ aufweist. Im Weiteren ist im hinteren Bereich eine den äusseren Gehäusemantel 3 durchdringende Bohrung 13 oder eine andere Ausnehmung ausgebildet. An der Innenwand 7 des äusseren Gehäusemantels 3 ist ein innerer Gehäusemantel 15 aus Kunststoff angespritzt. Der Kunststoff füllt die Bohrung 13 vorzugsweise vollständig aus und schliesst bündig mit der Aussenseite des äusseren Gehäusemantels 3 ab. Die Strukturen an der Innenwand 7 des äusseren Gehäusemantels verhindern eine Relativbewegung zwischen den beiden Gehäusemänteln 3, 15 selbst dann, wenn sich die durch den Spritzgiessvorgang erzeugte Haftverbindung zwischen den Mänteln 3, 15 lösen sollte. Bei Verwendung eines transparenten Kunststoffs für den inneren Gehäusemantel 15 oder zumindest für den Teil des Gehäusemantels 15 im Bereich von Bohrungen 13 können eine Leuchtdiode oder ein anderes optisches Anzeigemittel und/oder Elemente einer Infrarot-Kommunikationsschnittstelle so im Inneren des Gehäuses angeordnet werden, dass es von der Aussenseite her sichtbar ist. An der Innenseite des inneren Gehäusemantels 15 sind vorzugsweise zwei sich diametral gegenüberliegende, in Richtung der Gehäuseachse a verlaufende Führungsnuten 8 zum geführten Einschieben und Halten einer Leiterplatte bzw. eines mit elektronischen Bauteilen bestückten Prints 10 ausgenommen. Alternativ können auch Führungsrippen oder andere ins Gehäuseinnere vorstehende Führungselemente am inneren Gehäusemantel 15 ausgebildet sein. Vorzugsweise ist die Innenseite des inneren Gehäusemantels 15 zumindest im vorderen Bereich des Gehäuses in Richtung der Gehäuseachse a leicht konisch bzw. mit leichtem Anzug ausgebildet, derart, dass sich der Innendurchmesser d₂ zum frontseitigen Gehäuseende hin leicht vergrössert. Dadurch lässt sich nach dem Anspritzen des inneren Gehäusemantels 15 ein entsprechender Einschub der Spritzgussform leichter aus der Hülse herausziehen. Das frontseitige Ende des inneren Gehäusemantels 15 ist dünnwandig mit einem Absatz bzw. einer Schulter 16 mit grösserem Innendurchmesser d₃ zum Aufnehmen eines Schalenkerns 45 ausgebildet. Eine Zwischenwand oder ein Boden 17 trennt den vom inneren Gehäusemantel 15 umschlossenen Raum in einen vorderen Teilraum 19a und einen hinteren Teilraum 19b. Mehrere Kontaktelemente 21 sind in den Boden 17 eingespritzt bzw. vom Kunststoff des Bodens 17 teilweise umspritzt, derart, dass Kontaktstifte 23 zum Anschliessen eines Kabelsteckers nach hinten in den hinteren Teilraum 19b hineinragen. Der nach vorne in den vorderen Teilraum 19a hineinragende Teil jedes der Kontaktelemente 21 umfasst zwei sich gegenüberliegende, an zwei Gabelarmen 25 angeordnete Federkontakte bzw. Kontaktschneiden 27.

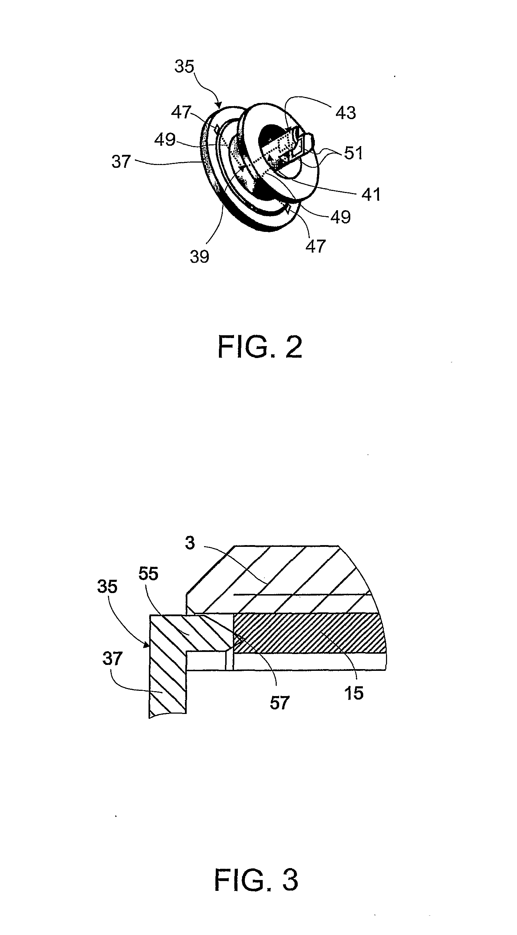

Figur 2 zeigt einen Abschlussdeckel bzw. eine Kappe oder Abschlusskappe 35 aus Kunststoff in einer besonders vorteilhaften Ausgestaltung. Sie umfasst entsprechend der Gestalt des Gehäuses eine runde Frontplatte 37, einen konzentrisch daran angeformten, einen Wellenstummel und einen Flansch umfassenden Spulenträger 39 und einen zylindrischen, zentrisch angeordneten Haltezapfen 41 mit einem gabelartig ausgebildeten Ende 43 zum Aufnehmen und Festklemmen eines Prints 10. Die Abschlusskappe 35 ist so ausgebildet, dass ein topfartiger Ferrit-Schalenkern 45 mit E-förmigem Querschnitt und einer Zentralbohrung derart auf den Haltezapfen 41 aufgeschoben bzw. aufgesteckt werden kann, dass er eine auf den Spulenträger 39 aufgewickelte Spule (nicht dargestellt) dreiseitig kanaloder torusartig ummantelt (Figur 1). Dabei überragt das hintere Ende 43 des zentralen Haltezapfens 41 die Bodenfläche 40 des Schalenkerns 45. Das vordere Ende des rechteckigen Prints 10 wird in der gabelartigen Ausnehmung am Haltezapfen 41 festgeklemmt. Die freien Enden des auf den Spulenträger 39 aufgewickelten Spulendrahtes werden direkt mit entsprechenden Kontaktstellen 46 auf dem Print 10 z.B. durch Löten verbunden. Alternativ können die Enden des Spulendrahtes auch indirekt mit Kontaktstellen auf dem Print 10 verbunden werden. Sie können z.B. mittels Laserlöten oder Bonden elektrisch leitend mit an der Abschlusskappe 35 ausgebildeten Metallisierungen 47 (Fig. 3) verbunden werden. Diese Metallisierungen 47 wiederum sind z.B. mittels in den Spulenträger 39 eingelassener oder eingespritzter Verbindungsdrähte oder Leiterbahnen 49 mit weiteren Kontaktelementen verbunden, beispielsweise mit an den Innenseiten des gabelartigen Endes 43 des Haltezapfens 41 ausgebildeten weiteren Metallisierungen 51. Die Kontaktstellen 46 auf dem Print 10 sind so angeordnet, dass beim Aufstecken der Abschlusskappe 35 auf den Print 10 eine elektrische Verbindung zwischen den Metallisierungen 51 am Haltezapfen 41 bzw. der Spule und den Kontaktstellen 46 auf dem Print 10 hergestellt wird. Die Spule bzw. allgemein das Sensorelement ist somit elektrisch mit der Sensorelektronik verbunden. Bei einer weiteren alternativen Ausführungsform sind anstelle der Metallisierungen 51 andere Kontaktelemente wie z.B. am Spulenträger 39 nach hinten hervorstehende Kontaktstifte oder Kontaktfedern bzw. Kontaktschneiden ausgebildet, die mit korrespondierenden Kontaktelementen auf dem Print 10, beispielsweise mit Anschlussflächen bzw. Kontaktstellen 46 oder mit Steckerbuchsen auf dem Print 10 verbunden werden (keine Darstellung).
Nachdem die Verbindung zwischen der Spule und dem Print 10 hergestellt worden ist, wird der Print 10 samt Abschlusskappe 35 von vorne her entlang der Führungen 8 in das Gehäuse eingeschoben, bis er im Bereich seines hinteren Endes zwischen den Gabelarmen 25 der Kontaktelemente 21 festgeklemmt ist und die Kontaktschneiden 27 ein- oder beidseitig auf dem Print 10 ausgebildete korrespondierende Pads bzw. Kontaktflächen 53 kontaktiert haben.
Bei der Ausgestaltung des Sensors gemäss Figur 1 gelangt der Schalenkern 45 beim Einschieben des Prints 10 in Anlage mit der Schulter 16 bzw. dem Absatz des frontseitig dünnwandig ausgebildeten inneren Gehäusemantels 15. In dieser Lage werden das vordere Ende des inneren Gehäusemantels 15 und der Rand der Frontplatte 37 miteinander dicht verbunden, beispielsweise durch Laserschweissen oder durch Kleben.

Figur 3 zeigt ein Detail eines weiteren Näherungsschalters 1 im Verbindungsbereich von Abschlusskappe 35 und innerem Gehäusemantel 15. Das vordere Ende des inneren Gehäusemantels 15 ist gegenüber dem vorderen Ende des äusseren Gehäusemantels 3 leicht ins Gehäuseinnere zurückversetzt. Die Abschlusskappe 35 umfasst einen umlaufenden Rand 55 mit einer messerartig geformten Schweisskante 57. Diese wird in Anlage mit dem vorderen Rand des inneren Gehäusemantels 15 gebracht und durch Beaufschlagung der Abschlusskappe 35 mit Ultraschallenergie mit dieser verschweisst.

## Patentansprüche

1. Induktiver Sensor umfassend ein mantelartiges Gehäuse mit einer frontseitig angebrachten Abschlusskappe (35), einen Print (10) mit einer Sensorelektronik und eine Spule als Sensorelement, wobei an der Abschlusskappe (35) eine das Gehäuse abschliessende Frontplatte (37) kreisförmig ausgebildet ist, und rückseitig an dieser Frontplatte (37) ein Spulenträger (39) ausgebildet ist, wobei der Spulenträger (39) als konzentrischer Wellenstummel mit einem daran angeformten Flansch ausgebildet ist, **dadurch gekennzeichnet, dass** die Frontplatte (37) und der Spulenträger (39) einstückig gebildet sind und an der Abschlusskappe (35) ein separater Haltezapfen (41) zum Halten des Prints (10) angeformt ist.

2. Induktiver Sensor nach Anspruch 1, **dadurch gekennzeichnet, dass** der Haltezapfen (41) ein gabelförmiges Ende zum Einstecken des Prints (10) umfasst.

3. Induktiver Sensor nach Anspruch 2, **dadurch gekennzeichnet, dass** die gabelförmigen Enden des Haltezapfens (41) Metallisierungen (51) umfassen, die mit korrespondierenden Kontaktstellen (46) auf dem Print (10) verbunden sind und den elektrischen Kontakt zwischen der Spule und dem Print (10) sicherstellen.

4. Induktiver Sensor nach Anspruch 3, **dadurch gekennzeichnet, dass** die Metallisierungen (51) mit weiteren Metallisierungen (47) zum Kontaktieren der Spulenenden an der Abschlusskappe (35) elektrisch verbunden sind.

5. Induktiver Sensor nach einem der Ansprüche 1 und 2, **dadurch gekennzeichnet, dass** an der Abschlusskappe (35) nach hinten hervorragende Kontaktstifte oder Kontaktfedern oder Kontaktschneiden ausgebildet sind.

6. Abschlusskappe (35) für einen induktiven Sensor, mit einem an einer kreisförmigen Frontplatte (37) der Abschlusskappe (35) rückseitig ausgebildeten Spulenträger (39), wobei der Spulenträger (39) als konzentrischer Wellenstummel mit einem daran angeformten Flansch ausgebildet ist, **dadurch gekennzeichnet dass,** die Frontplatte (37) und der Spulenträger (39) einstückig gebildet sind und an der Abschlusskappe (35) ein separater Haltezapfen (41) zum Halten des Prints (10) angeformt ist.

7. Abschlusskappe (35) für einen induktiven Sensor nach Anspruch 6, **dadurch gekennzeichnet dass** Metallisierungen (47, 51) durch Leiterbahnen (49), elektrisch verbunden sind.

## Claims

1. Inductive sensor, comprising a jacket-type casing with an end cap (35) mounted on the front, a pcb (10) with the sensor electronics and a coil as the sensor element with a circular front plate (37) closing off the casing at the end cap (35) and a coil carrier (39) is mounted at the rear of this front plate (37), whereby the coil carrier (39) is designed as a concentric stub shaft with a formed flange, **characterized such that** the front plate (37) and the coil carrier (39) are designed as one piece and a separate retaining pin (41) is formed on the end cap (35) to hold the pcb (10).

2. Inductive sensor in accordance with Patent Claim 1, **characterized such that** the retaining pin (41) features a fork-shaped end which is plugged into the pcb (10).

3. Inductive sensor in accordance with Patent Claim 2, **characterized such that** the fork-shaped ends of the retaining pin (41) feature metallized elements (51) that are connected to corresponding contact points (46) on the pcb (10), thus ensuring electrical contact between the coil and pcb (10).

4. Inductive sensor in accordance with Patent Claim 3, **characterized such that** the metallized elements (51) are connected to other metallized elements (47) to electrically connect the coil ends to the end cap (35)

5. Inductive sensor in accordance with Patent Claims 1 and 2, **characterized such that** rear-protruding contact pins or contact springs or contact cutters are formed on the end cap (35).

6. End cap (35) for an inductive sensor with a coil carrier (39) formed on the rear of the circular front plate (37) of the end cap (35), whereby the coil carrier (39) is designed as a concentric stub shaft with attached flange, **characterized such that** the front plate (37) and the coil carrier (39) are formed as one piece and a separate retaining pin (41) is formed on the end cap (35) for holding the pcb (10).

7. End cap (35) for an inductive sensor in accordance with Patent Claim 6, **characterized such that** the metallized elements (47, 51) are electrically connected by conductors (49).

## Revendications

1. Détecteur inductif comprenant un boîtier de type enveloppe avec un capot de recouvrement sur la face avant (35), une plaquette à circuit imprimé (10) avec l'électronique du détecteur et une bobine comme élément détecteur, une plaque frontale (37) refermant le boîtier étant conçue de forme circulaire sur le capot de recouvrement (35), et un support de bobine (39) étant conçu au dos de cette plaque frontale (37), le support de bobine (39) étant conçu comme un bout d'arbre concentrique doté d'une flasque formée dessus, **caractérisé en ce que** la plaque frontale (37) et le support de bobine (39) sont formés en une seule pièce et un ergot séparé (41) pour fixer la plaquette à circuit imprimé (10) est formé sur le capot de recouvrement (35).

2. Détecteur inductif selon la revendication 1, **caractérisé en ce que** l'ergot (41) comprend une extrémité fourchue pour enficher la plaquette à circuit imprimé (10).

3. Détecteur inductif selon la revendication 2, **caractérisé en ce que** les extrémités fourchues de l'ergot (41) comprennent des métallisations (51), qui sont raccordées aux points de contact correspondants (46) sur la plaquette à circuit imprimé (10) et assurent le contact électrique entre la bobine et la plaquette à circuit imprimé (10).

4. Détecteur inductif selon la revendication 3, **caractérisé en ce que** les métallisations (51) sont raccordées électriquement à d'autres métallisations (47) pour le contact des extrémités de bobine sur le capot de recouvrement (35).

5. Détecteur inductif selon l'une des revendications 1 et 2, **caractérisé en ce que** des broches ou des ressorts de contact ou des lames de contact faisant saillie vers l'arrière sont conçus sur le capot de recouvrement (35).

6. Capot de recouvrement (35) pour un détecteur inductif, avec un support de bobine (39) conçu au dos d'une plaque frontale (37) de forme circulaire du capot de recouvrement (35), le support de bobine (39) étant conçu comme un bout d'arbre concentrique doté d'une flasque formée dessus, **caractérisé en ce que** la plaque frontale (37) et le support de bobine (39) sont formés en une seule pièce et un ergot séparé (41) pour fixer la plaquette à circuit imprimé (10) est formé sur le capot de recouvrement (35).

7. Capot de recouvrement (35) pour un détecteur inductif selon la revendication 6, **caractérisé en ce que** des métallisations (47, 51) sont raccordées électriquement par le biais de pistes de connexion (49).
